# EUROPÄISCHE PATENTSCHRIFT

(11) **EP 1 854 996 B1**
(45) Veröffentlichungstag und Bekanntmachung des Hinweises auf die Patenterteilung: **05.11.2008**
(21) Anmeldenummer: 06009445.5
(22) Anmeldetag: 08.05.2006
(51) Int. Cl.: F02M 63/00, F02M 61/16, H01L 41/053, H01L 41/083

(54) **Piezo-Aktor, Verfahren zum Herstellen eines Piezo-Aktors und Einspritzsystem mit einem solchen**
Piezoelectric actuator, method for the production of a piezoelectric actuator and injection system with such an actuator
Actionneur piézo-électrique, procédé de fabrication d'un actionneur piézo-électrique et système d'injection comportant cet actionneur piézo-électrique

(43) Veröffentlichungstag der Anmeldung: 14.11.2007
(73) Patentinhaber: Continental Automotive GmbH, 30165 Hannover (DE)
(72) Erfinder: Kronberger, Maximilian, Dr., 93053 Regensburg (DE)

(56) Entgegenhaltungen:
- US-A1- 2005 072 863
- US-B1- 6 552 472
- US-B1- 6 899 284

## Beschreibung

Die Erfindung betrifft einen Piezo-Aktor, ein Verfahren zum Herstellen eines Piezo-Aktors und ein Einspritzsystem mit einem Piezo-Aktor.

Einspritzsysteme und insbesondere lecköllose Common-Rail-Einspritzsysteme erfordern ein Steuerelement wie beispielsweise einen Piezo-Aktor im Hochdruckraum. Um die Arbeitsfähigkeit des Piezo-Aktors auch unter hohen Drücken bis über 2000 bar zu gewährleisten, muss der Druck auch seitlich auf den Piezo-Stapel beziehungsweise Piezo-Keramikkörper wirken können, um die Dehnungsfähigkeit des Piezo-Stapels des Piezo-Aktors zu unterstützen.

Ein solcher Piezo-Aktor ist beispielsweise in der WO 02/061856 A1 beschrieben. Dabei ist der Keramikkörper dieses Piezo-Aktors mit einer Polymer- oder Plastikmanschette umhüllt. Allerdings ist eine hermetische Abdichtung des Keramikkörpers gegenüber dem Kraftstoff unter einem hohen Kraftstoffdruck wie beispielsweise 2000 bar bei den zum Anmeldetag der vorliegenden Patentanmeldung bekannten Kunststoffen kaum oder nicht machbar. Wegen einer fallweise unvermeidbaren elektrischen Leitfähigkeit handelsüblicher Kraftstoffe, zum Beispiel aufgrund eines geringen Säuregehalts, kann es schon bei geringer Benetzung der Piezo-Keramik zu Spannungsüberschlägen zwischen den Innenelektroden des Piezo-Aktors kommen. Zudem treten an den Polungsrissen hohe Dehnungen der Kunststoffumhüllung auf, die dieses Problem verschärfen. Außerdem ist in der WO 02/061856 die Verwendung eines Füllmaterials zwischen dem Piezo-Stapel und der Polymer- oder Plastikmanschette beschrieben. Bei dem beschriebenen Füllmaterial besteht allerdings das Problem, dass es bei einer Dehnung des Piezo-Stapels in entstehende Zwischenräume oder Fugen fließen kann und bei einer entgegengesetzt gerichteten Bewegung des Piezo-Stapels zerstört werden kann. Somit wird über die Betriebsdauer des Piezo-Aktors das Füllmaterial aufgebraucht oder zerstört. Das verminderte Füllmaterial bedingt allerdings, dass der außen an dem Piezo-Aktor anliegende Druck nicht mehr effizient auf den Piezo-Stapel übertragen werden kann.

Aus US 6 899 284 B1 ist ein Kraftstoffinjektor mit einem piezoelektrischen Aktor bekannt, der in einem Aktorgehäuse angeordnet ist. Das Aktorgehäuse ist aus einem Material, das keinen oder einen negativen Temperaturausdehnungskoeffizienten hat, so dass die Temperaturausdehnung des Aktorgehäuses und des Einspritzventilelements im Wesentlichen der Temperaturausdehnung des Aktors und der Temperaturausdehnung des Aktors und des Übertragungselements entspricht.

Außerdem ist der Anmelderin zur Übertragung des Druckes auf den Piezo-Stapel des Piezo-Aktors eine Lösung mit einer hermetisch dichten, metallischen Hülse bekannt, welche die hydraulischen Kräfte mittels einer Flüssigkeit, wie beispielsweise einem Silikon-Öl, auf die Seitenflächen des Piezo-Keramikkörpers überträgt. Diese der Anmelderin intern bekannte Lösung hat allerdings den Nachteil, dass der Wärmeausdehnungskoeffizient von Silikon-Öl um Größenordnungen über dem der metallischen Hülse liegen.

Infolgedessen steigen insbesondere die Zugspannungen in der metallischen Hülse bei einer Temperaturerhöhung an. Die Zugspannungen könnten durch geeignete Ausformungen der Dehnfalten der metallischen Hülse bzw. des Metallbalges in Längs- und Querrichtung vermindert werden. Allerdings steigt bei einem quaderförmigen Piezo-Stapel, der im Vergleich zu Piezo-Stapeln mit anderen Querschnittsformen kostengünstiger ist, wegen des verhältnismäßig großen Volumens der Flüssigkeit das Spannungsniveau dennoch unzulässig hoch an. Da der Keramikwerkstoff des Piezo-Stapels eine sehr geringe Wärmeausdehnung besitzt, ist der Anmelderin ferner intern bekannt, das Volumen des Piezo-Stapels im Vergleich zur Füllung so groß wie möglich auszuführen. Dazu könnte beispielsweise der Piezo-Stapel kreiszylindrisch ausgebildet werden.
Die kreiszylindrische Ausbildung des Piezo-Stapels ist allerdings in der Fertigung erheblich aufwändiger und somit deutlich kostenintensiver als ein quaderförmiger Piezo-Stapel.

Eine Aufgabe der vorliegenden Erfindung besteht daher darin, einen Piezo-Aktor bereitzustellen, bei welchem ein außen an den Piezo-Aktor anliegender Druck auf den Piezo-Stapel des Piezo-Aktors möglichst effizient übertragen und insbesondere verteilt wird.

Eine weitere Aufgabe ist es, einen Piezo-Aktor zu schaffen, welcher insbesondere auch in einer Umgebung hohen Druckes, beispielsweise auch bei über 2000 bar, vor Spannungsüberschlägen geschützt ist.

Des Weiteren ist es eine Aufgabe, einen Piezo-Aktor bereitzustellen, bei welchem ein außen an den Piezo-Aktor anliegender Druck den Piezo-Stapel unter einen quasi-isostatischen allseitigen Druck setzt.

Außerdem ist eine Aufgabe der vorliegenden Erfindung, einen Piezo-Aktor bereitzustellen, der eine möglichst große Lebensdauer besitzt.

Insbesondere ist es dabei eine Aufgabe, die metallische Hülse bzw. den Metallbalg vor hohen oder zu hohen Beanspruchungen in Folge hoher Temperaturen, hohen Drücken, hohen Temperaturänderungen und/oder hohen Druckänderungen zu schützen und damit eine hohe Lebensdauer für den Piezo-Aktor bereitzustellen.

Erfindungsgemäß wird zumindest eine dieser gestellten Aufgaben durch einen Piezo-Aktor mit den Merkmalen des Patentanspruchs 1 und/oder durch ein Verfahren zum Herstellen eines Piezo-Aktors mit den Merkmalen des Patentanspruchs 14 gelöst.

Demnach wird erfindungsgemäß ein Piezo-Aktor zum Einspritzen von Kraftstoff mit einem vorbestimmten Kraftstoffdruck vorgeschlagen, der aufweist:
- eine einen Aktor-Innenraum zumindest seitlich begrenzende Umhüllung, welche eine temperatur- und/oder druckabhängige erste Volumenänderung aufweist,
- einen in dem Aktor-Innenraum angeordneten Piezo-Stapel, welcher eine temperatur- und/oder druckabhängige zweite Volumenänderung aufweist,
- ein zwischen dem Piezo-Stapel und der Umhüllung angeordnetes Übertragungsmittel zum Übertragen des außen an der Umhüllung anliegenden Kraftstoffdrucks auf den Piezo-Stapel,
wobei das Übertragungsmittel eine passivierende Flüssigkeit, welches eine temperatur- und/oder druckabhängige dritte Volumenänderung aufweist, und mehrere vorgeformte Körper aufweist, welche eine temperatur- und/oder druckabhängige vierte Volumenänderung aufweisen, wobei das Verhältnis zwischen der passivierenden Flüssigkeit und den vorgeformten Körpern derart eingestellt ist, dass die erste Volumenänderung der Umhüllung einer Gesamtvolumenänderung des Aktor-Innenraums, welche zumindest die zweite, dritte und vierte Volumenänderung umfasst, im Wesentlichen entspricht.

Im Sinne dieser Anmeldung bedeutet vorgeformt, dass die vorgeformten Körper eine vorbestimmbare und vorbestimmte Form aufweisen.

Das erfindungsgemäße Übertragungsmittel mit der Flüssigkeit ist vorteilhafterweise passivierend, so dass ein Spannungsüberschlag zwischen dem Piezo-Aktor und jeglichen außerhalb des Übertragungsmittels angeordneten Einheiten oder Elementen, wie beispielsweise der Umhüllung des Piezo-Stapels, vermieden wird.

Ein weiterer Vorteil des erfindungsgemäßen Übertragungsmittels ist es, dass es einen außen der Umhüllung anliegenden Druck, insbesondere den Kraftstoffdruck, auf den Piezo-Stapel übertragen und insbesondere homogen verteilen kann. Somit wird die Dehnungsfähigkeit des Piezo-Stapels durch den lateral einwirkenden Kraftstoffdruck unterstützt, wodurch die Betriebseigenschaften des Piezo-Aktors deutlich verbessert werden.

Ein weiterer Vorteil des erfindungsgemäßen Piezo-Aktors ist es, dass die Volumenänderung der Umhüllung in Folge von Temperatur- und/oder Druckänderungen im Wesentlichen der Volumenänderung des Aktor-Innenraums entspricht. Somit werden Beanspruchungen der Umhüllung in Folge von Temperatur- und/oder Druckänderungen minimiert, sodass die Lebensdauer der Umhüllung und somit die Lebensdauer des Piezo-Aktors maximiert wird.

Ein weiterer Vorteil des erfindungsgemäßen Übertragungsmittels ist seine optimale Zusammensetzung hinsichtlich seiner Wärmeausdehnung und seiner Druckübertragungsfähigkeit. Dabei dient die passivierende Flüssigkeit zur homogenen Übertragung des Kraftstoffdruckes auf den Piezo-Stapel und zur Verminderung der inneren Reibung des Übertragungsmittels bzw. der vorgeformten Körper zwischen Umhüllung und Piezo-Stapel. Die durch die Flüssigkeit bereitgestellte erhöhte Beweglichkeit des Übertragungsmittels bzw. der vorgeformten Körper dient zum Ausgleich der unterschiedlichen örtlichen Verformungen in der Umhüllung in Folge des äußeren Kraftstoffdruckes und des Arbeitshubs des Piezo-Aktors. Dahingegen dienen die vorgeformten Körper zur Verminderung der Wärmedehnung des gesamten Übertragungsmittels und weiterhin zur Erhöhung der Steifigkeit des Übertragungsmittels.

Vorteilhafte Ausgestaltungen und Weiterbildungen der Erfindung ergeben sich aus den Unteransprüchen sowie der Beschreibung unter Bezugnahme auf die Zeichnungen.

Gemäß einer bevorzugten Ausgestaltung der Erfindung ist der Aktor-Innenraum durch eine Kopfplatte, eine Bodenplatte, die Umhüllung und durch den Piezo-Stapel begrenzt.

Gemäß einer weiteren bevorzugten Ausgestaltung liegt eine Differenz zwischen der Gesamtvolumenänderung des Aktor-Innenraums und der ersten Volumenänderung der Umhüllung in einem vorbestimmten Toleranzbereich. In der Praxis ist es herstellungsbedingt sehr schwierig, die Gesamtvolumenänderung des Aktor-Innenraums durch Einstellen des Verhältnisses zwischen der passivierenden Flüssigkeit und den vorgeformten Körpern derart einzustellen, dass sie der ersten Volumenänderung exakt entspricht. Demnach wird ein Toleranzbereich vorbestimmt, in dem Änderungen von unter 30%, bevorzugt unter 10%, besonders bevorzugt unter 5%, zulässig sind. In Abhängigkeit dieses vorbestimmten Toleranzbereichs wird dann das Verhältnis zwischen passivierender Flüssigkeit und den vorgeformten Körpern eingestellt.

Gemäß einer weiteren bevorzugten Ausgestaltung ist der Piezo-Stapel quaderförmig, vieleckig oder kreiszylindrisch ausgebildet.

Gemäß einer weiteren bevorzugten Ausgestaltung ist die Umhüllung als ein Wellrohr ausgebildet, welches eine Vielzahl von N Wellen aufweist und insbesondere metallisch ist. Durch die wellrohrartige Ausgestaltung der Umhüllung wird erfindungsgemäß die Aufnahme von Relativbewegungen verbessert. Das Wellrohr ist insbesondere metallisch und ermöglicht es vorteilhafterweise auch bei einer unvermeidbaren elektrischen Leitfähigkeit handelsüblicher Kraftstoffe, den Piezo-Aktor vor Spannungsüberschlägen zu schützen.

Gemäß einer weiteren bevorzugten Ausgestaltung ist die passivierende Flüssigkeit als ein Silikon-Öl ausgebildet.

Gemäß einer weiteren bevorzugten Ausgestaltung sind die vorgeformten Körper als eine Vielzahl von Kügelchen ausgebildet, welche insbesondere jeweils einen Durchmesser von höchstens 200 µm aufweisen und/oder aus einer Oxyd-Keramik bestehen. Oxyd-Keramikkügelchen haben den besonderen Vorteil, ähnliche oder gleiche Wärmeausdehnungskoeffizienten wie der keramische Piezo-Stapel zu haben. Zur Gewährleistung einer optimalen Beweglichkeit der Kügelchen haben diese einen Durchmesser von höchstens 200 µm.

Gemäß einer weiteren bevorzugten Ausgestaltung sind die Kügelchen in der passivierenden Flüssigkeit in der dichtesten Kugelpackung angeordnet. Somit wird vorteilhafterweise eine Entmischung der Kügelchen und der passivierenden Flüssigkeit verhindert. Eine Entmischung hätte nachteiligerweise zur Folge, dass der Aktor-Innenraum eine nicht unerhebliche Ungleichverteilung der Kügelchen aufwiese, welche eine inhomogene Druckübertragung bzw. Druckverteilung auf den Piezo-Stapel zur Folge hätte.

Gemäß einer weiteren bevorzugten Ausgestaltung sind die vorgeformten Körper als elastische Übertragungselemente ausgebildet, wobei vorzugsweise in zumindest einer Welle zumindest zwei an die Wellenform angepasste elastische Übertragungselemente angeordnet sind. Das Übertragungselement der vorliegenden Erfindung ist vorgeformt und elastisch und besitzt somit nur geringe viskose Eigenschaften, sodass ein Fließen des Übertragungselementes in die Fugen des Piezo-Stapels weitgehend vermieden wird oder unmöglich ist. Im Sinne dieser Anmeldung bedeutet elastisch, dass das besagte Mittel nur eine geringe Viskosität aufweist und somit nicht in enge Spalte verfließen kann. Elastisch bedeutet also im Wesentlichen nicht-viskos oder nur sehr gering viskos. Vorgeformt bedeutet, dass das Mittel eine vorbestimmbare und vorbestimmte Form aufweist. Nachdem das erfindungsgemäße Übertragungselement nicht in die Fugen des Piezo-Stapels fließen kann, kann es auch nicht durch den bewegten Piezo-Stapel, insbesondere beim Betrieb des Piezo-Aktors, zwischen den Fugen zerstört werden. Somit ergibt sich eine erheblich längere Lebensdauer für das erfindungsgemäße Übertragungselement.

Gemäß einer weiteren bevorzugten Ausgestaltung ist das elastische Übertragungselement aus Stahl und/oder Keramik und/oder Invar und/oder Nylon (PA66) und/oder aus einem Elastomer, insbesondere Teflon, ausgebildet.

Gemäß einer weiteren bevorzugten Ausgestaltung ist das Wellrohr als ein längs- und querdehnfähiges Wellrohr ausgebildet.

Gemäß einer weiteren bevorzugten Ausgestaltung ist das Übertragungsmittel zwischen der Umhüllung und dem Piezo-Stapel formschlüssig und/oder kraftschlüssig angeordnet. Das formschlüssige und kraftschlüssige Übertragungsmittel ist insbesondere vorteilhafterweise dazu geeignet, den außen an der Umhüllung anliegenden Druck auf die sehr steife Piezo-Keramik abzuleiten und so die in der Umhüllung entstehende Druckdifferenz möglichst gering zu halten. Außerdem ist das elastische Übertragungselement vorzugsweise an den Übergangsbereichen zu dem Piezo-Stapel und zu der Umhüllung großflächig ausgebildet, sodass die elastische Verformbarkeit vorteilhafterweise maximiert wird.

Gemäß einer weiteren bevorzugten Ausgestaltung ist der Wärmeausdehnungskoeffizient der vorgeformten Körper um das Zehnfache bis Fünfzigfache, bevorzugt um das Zwanzigfache bis Vierzigfache, besonders bevorzugt um das Fünfundzwanzigfache bis Dreißigfache, kleiner als der Wärmeausdehnungskoeffizient der passivierenden Flüssigkeit.

Die Erfindung wird nachfolgend anhand der in den schematischen Figuren angegebenen Ausführungsbeispielen näher erläutert. Es zeigen:
- Figur 1: eine schematische Längsschnittansicht eines ersten Ausführungsbeispiels des erfindungsgemäßen Piezo-Aktors;
- Figur 2: eine schematische Querschnittsansicht eines zweiten Ausführungsbeispiels des erfindungsgemäßen Piezo-Aktors;
- Figur 3: eine schematische Querschnittsansicht eines dritten Ausführungsbeispiels des erfindungsgemäßen Piezo-Aktors;
- Figur 4: ein schematisches Ablaufdiagramm des erfindungsgemäßen Verfahrens zur Herstellung eines Piezo-Aktors; und
- Figur 5: ein Diagramm zur Darstellung der entstehenden maximalen Hauptnormalspannungen in Abhängigkeit des Mischungsverhältnisses des Übertragungsmittels.

In allen Figuren sind gleiche bzw. funktionsgleiche Elemente und Gegenstände - sofern nichts anderes angegeben ist - mit denselben Bezugszeichen versehen worden.

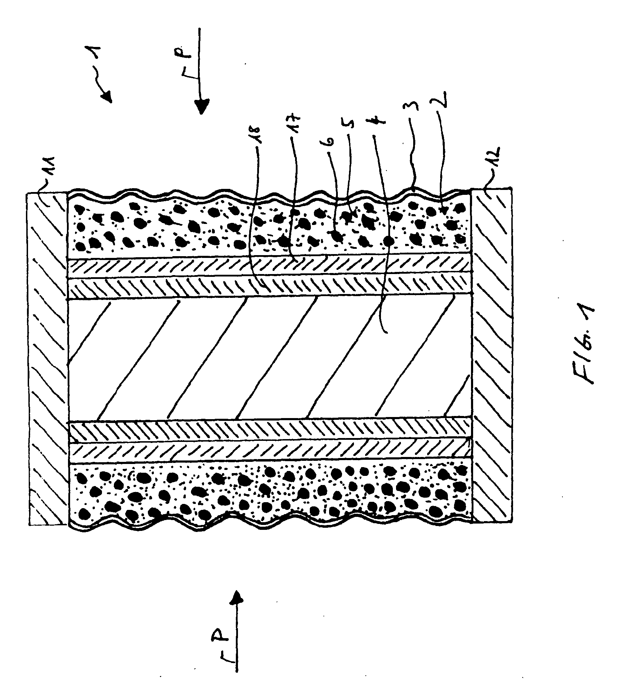

Die im Folgenden erläuterten Ausführungsbeispiele des erfindungsgemäßen Piezo-Aktors 1 nach den Figuren 1 bis 3 haben das Folgende gemein:

Der erfindungsgemäße Piezo-Aktor 1 zum Einspritzen von Kraftstoff mit einem vorbestimmten Kraftstoffdruck P weist eine einen Aktor-Innenraum 2 zumindest seitlich begrenzende Umhüllung 3, einen in dem Aktor-Innenraum 2 angeordneten Piezo-Stapel 4 und ein Übertragungsmittel 5; 6, 7-10 zum Übertragen des außen an der Umhüllung 3 anliegenden Kraftstoffdrucks P auf den Piezo-Stapel 4 auf. Das Übertragungsmittel 5; 6, 7-10 ist zwischen dem Piezo-Stapel 4 und der Umhüllung 3 angeordnet.

Die Umhüllung 3 weist eine temperatur- und/oder druckabhängige erste Volumenänderung ΔV1 auf. Das bedeutet, dass sich das Volumen der Umhüllung 3 in Folge einer Druckänderung und/oder einer Temperaturänderung ändert. Weiter ist der Aktor-Innenraum 2 durch eine Kopfplatte 11, eine Bodenplatte 12, die Umhüllung 3 und durch den Piezo-Stapel 4 begrenzt. Die Umhüllung 3 ist vorzugsweise als ein Wellrohr ausgebildet, welches eine Vielzahl von N Wellen aufweist und insbesondere metallisch ist. Das Wellrohr 3 ist insbesondere als ein längs- und querdehnfähiges Wellrohr ausgebildet.

Der in dem Aktor-Innenraum 2 angeordnete Piezo-Stapel 4 weist eine temperatur- und/oder druckabhängige zweite volumenänderung ΔV2 auf. Der Piezo-Stapel 4 ist vorzugsweise quaderförmig, vieleckig oder kreiszylindrisch ausgebildet.

Das Übertragungsmittel 5; 6, 7-10 weist eine passivierende Flüssigkeit 5, welche eine temperatur- und/oder druckabhängige dritte Volumenänderung ΔV3 aufweist, und mehrere vorgeformte Körper 6, 7-10 auf, welche eine temperatur- und/oder druckabhängige vierte Volumenänderung ΔV4 aufweisen. Die passivierende Flüssigkeit 5 ist vorzugsweise ein Silikon-Öl. Gemäß der vorliegenden Erfindung wird das Verhältnis, insbesondere das Mengenverhältnis, zwischen der passivierenden Flüssigkeit 5 und den vorgeformten Körpern 6,7-10 derart eingestellt, dass die erste Volumenänderung ΔV1 der Umhüllung 3 einer Gesamtvolumenänderung ΔVin des Aktor-Innenraums 2 im Wesentlichen entspricht. Dabei beinhaltet die Gesamtvolumenänderung ΔVin sämtliche Volumenänderungen der im Aktor-Innenraum 2 befindlichen Vorrichtungen oder Körper. So umfasst die Gesamtvolumenänderung ΔVin des Aktor-Innenraum 2 zumindest die zweite Volumenänderung ΔV2 des Piezo-Stapels 4, die dritte Volumenänderung ΔV3 der passivierenden Flüssigkeit 5 sowie die vierte Volumenänderung ΔV4 der mehreren vorgeformten Körper 6, 7-10.

Die Differenz zwischen der Gesamtvolumenänderung ΔVin des Aktor-Innenraums 2 und der ersten Volumenänderung ΔV1 der Umhüllung 3 liegt in einem vorbestimmten Toleranzbereich, der Abweichungen von kleiner gleich 30%, bevorzugt von kleiner gleich 10%, besonders bevorzugt von kleiner gleich 5% beinhaltet. Solange die Differenz zwischen der Gesamtvolumenänderung ΔVin des Aktor-Innenraums 2 und der ersten Volumenänderung ΔV1 der Umhüllung 3 in dem vorbestimmten Toleranzbereich liegt, wird die erfindungsgemäße Funktion, nämlich die Minimierung der Beanspruchung der Umhüllung 3 in Folge von Temperatur- und/oder Druckänderungen, insbesondere des Kraftstoffdruckes P, verwirklicht.

Dabei ist der Wärmeausdehnungskoeffizient der vorgeformten Körper 6, 7-10 insbesondere um das Zehnfache bis Fünfzigfache, bevorzugt um das Zwanzigfache bis Vierzigfache, besonders bevorzugt um das Fünfundzwanzigfache bis Fünfunddreißigfache, kleiner als der Wärmeausdehnungskoeffizient der passivierenden Flüssigkeit 5.

Im Folgenden wird detailliert der strukturelle Aufbau des Piezo-Aktors 1 gemäß der drei Ausführungsbeispiele nach den Figuren 1 bis 3 erläutert.

Der erfindungsgemäße Piezo-Aktor 1 nach Figur 1 ist zwischen der Kopfplatte 11 und der Bodenplatte 12 angeordnet. Die Umhüllung 3 umgibt den Piezo-Aktor 1 seitlich. Die Umhüllung 3 ist vorzugsweise mit der Kopfplatte 11 und der Bodenplatte 12 verbunden. Zwischen der Umhüllung 3 und dem Piezo-Stapel 4 existiert ein Aktor-Innenraum 2. In dem Aktor-Innenraum 2 sind auf dem Piezo-Stapel 4 eine erste Elektrodenschicht 18a, welche beispielsweise mit einem positiven Versorgungspotential verbunden ist, und eine zweite Elektrodenschicht 18b, welche beispielsweise mit einem negativen Versorgungspotential verbunden ist, angeordnet. Auf den Elektrodenschichten 18a, 18b ist rotationssymetrisch eine Passivierungsschicht 17 angeordnet. Zwischen der Passivierungsschicht 17 und der Umhüllung 3 ist das Übertragungsmittel 5, 6 gefüllt, welches die passivierende Flüssigkeit 5 sowie die Keramikkügelchen 6 aufweist.

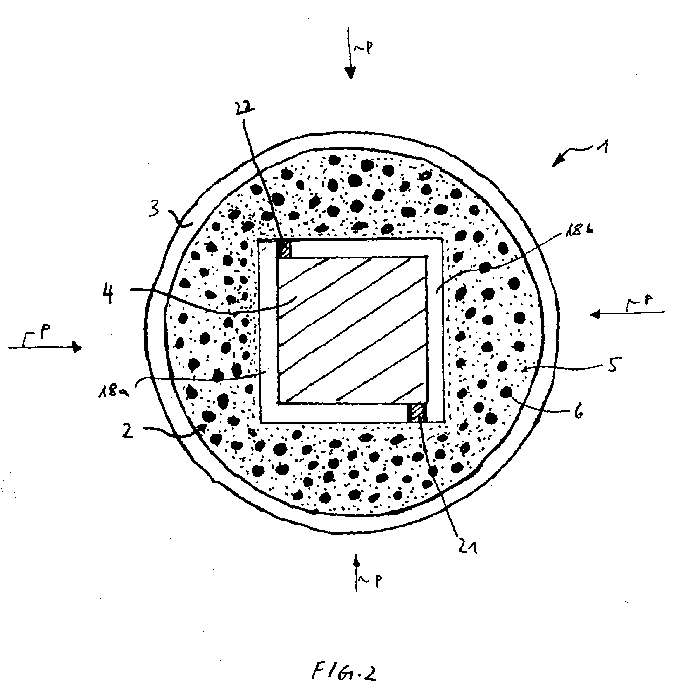

Figur 2 zeigt eine Querschnittsansicht eines zweiten Ausführungsbeispiels des erfindungsgemäßen Piezo-Aktors 1. Der strukturelle Aufbau des Piezo-Aktors 1 nach Figur 2 unterscheidet sich von dem nach Figur 1 dahingehend, dass keine Passivierungsschicht 17 vorgesehen ist. Diese ist nicht zwingend notwendig, da die Flüssigkeit 5 selbst passivierend ist. Die Elemente mit den Bezugszeichen 21 und 22 bezeichnen Trennelemente, welche die beiden Elektrodenschichten 18a und 18b elektrisch voneinander trennen.

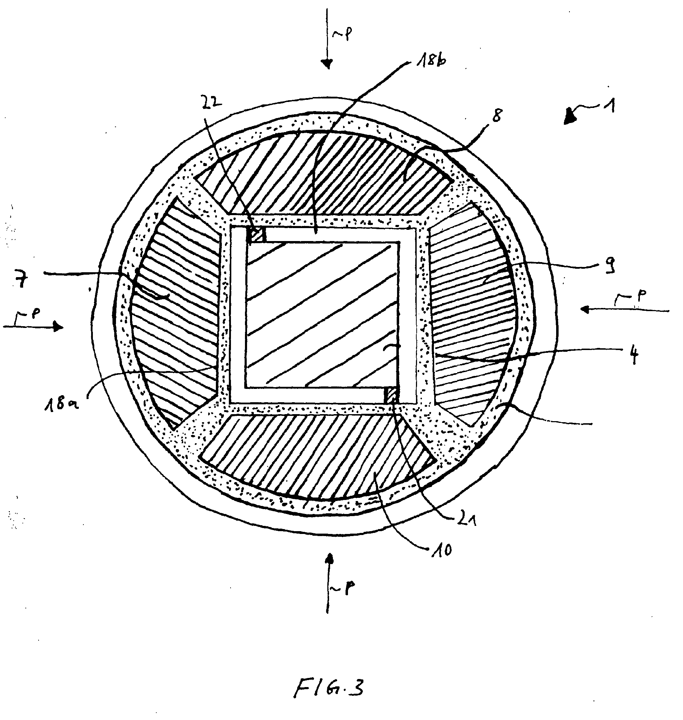

In Figur 3 ist eine Querschnittsansicht eines dritten Ausführungsbeispiels des erfindungsgemäßen Piezo-Aktors 1 dargestellt. Das dritte Ausführungsbeispiel gemäß Figur 3 unterscheidet sich von dem zweiten Ausführungsbeispiel nach Figur 2 dahingehend, dass die vorgeformten Körper 7-10 des Übertragungsmittels als elastische Übertragungselemente 7-10 ausgebildet sind. Die elastischen Übertragungselemente 7-10 sind beispielsweise Einlegeteile, welche als mit der Welle und mit dem Piezo-Stapel 4 formangepasste Scheibenabschnitte ausgebildet sind. Die Einlegeteile 7-10 sind insbesondere vollständig mit der Flüssigkeit 5 umgeben oder umspült.

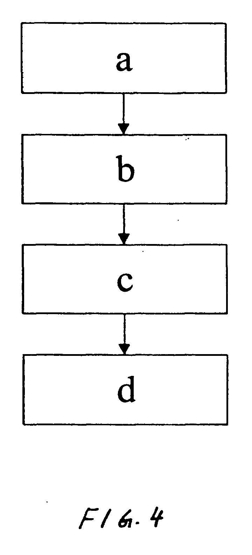

Nachfolgend wird das erfindungsgemäße Verfahren zum Herstellen eines Piezo-Aktors 1 anhand des Blockschaltbildes in Figur 4 erläutert. Das erfindungsgemäße Verfahren weist folgende Verfahrensschritte a bis d auf.

### Verfahrensschritt a:

Es wird ein Piezo-Stapel 4 in einem Aktor-Innenraum 2 angeordnet, wobei der Piezo-Stapel 4 eine temperatur- und/oder druckabhängige zweite Volumenänderung ΔV2 aufweist.

### Verfahrensschritt b:

Der Aktor-Innenraum 2 wird zumindest seitlich mittels einer Umhüllung 3 begrenzt. Die Umhüllung 3 weist eine temperatur- und/oder druckabhängige erste Volumenänderung ΔV1 auf.

### Verfahrensschritt c:

Der verbleibende Aktor-Innenraum 2 zwischen dem Piezo-Stapel 4 und der Umhüllung 3 wird mit einer passivierenden Flüssigkeit 5 gefüllt. Die Flüssigkeit 5 weist eine temperatur- und/oder druckabhängige dritte Volumenänderung ΔV3 auf.

### Verfahrensschritt d:

Eine Gesamtvolumenänderung ΔVin, welche zumindest die zweite, dritte und vierte Volumenänderung ΔV2-ΔV4 umfasst, wird mittels Packen von mehreren vorgeformten Körpern 6, 7-10, welche eine temperatur- und/oder druckabhängige vierte Volumenänderung ΔV4 aufweisen, in die passivierende Flüssigkeit 5 derart eingestellt, dass die Gesamtvolumenänderung ΔVin des Aktor-Innenraums 2 der ersten Volumenänderung ΔV1 der Umhüllung 3 im Wesentlichen entspricht.

Das Verfahren gemäß Figur 4 ist nicht auf die beschriebene Reihenfolge beschränkt. So können beispielsweise die Verfahrensschritte a und d vertauscht werden.

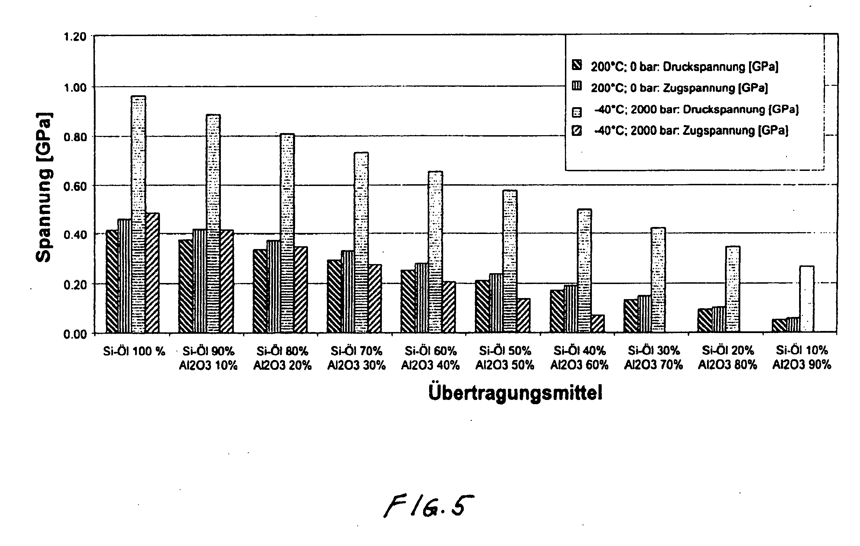

Figur 5 zeigt ein Diagramm zur Darstellung der entstehenden maximalen Hauptnormalspannungen an der Umhüllung 3 in Abhängigkeit des Mischverhältnisses des Übertragungsmittels. Die Abszisse zeigt verschiedene Mischungen des Übertragungsmittels. Nach dem Ausführungsbeispiel gemäß Figur 5 besteht das Übertragungsmittel aus einer Mischung aus einem Siliziumöl Si-Öl und Keramikkügelchen aus Aluminium-Oxyd Al₂O₃. Auf der Ordinate sind demgegenüber die Spannungen, die Druckspannung und die Zugspannung, in GPa dargestellt. Das Diagramm gemäß Figur 5, welches das Ergebnis einer von der Anmelderin durchgeführten Berechnung ist, zeigt, dass die Spannungen mit Zunahme des Anteils von Al₂O₃ im Übertragungsmittel stetig abnehmen. Das Versuchsergebnis gemäß Figur 5 verdeutlicht, dass der Anteil der Flüssigkeit Si-Öl gegenüber dem Anteil Al₂O₃ minimal zur Reduktion der Spannungen sein soll, wobei der Anteil der Flüssigkeit Si-Öl gerade noch so hoch sein soll, dass keine Entmischung von Keramikkügelchen Al₂O₃ und Flüssigkeit Si-Öl entstehen kann.

Der erfindungsgemäße Piezo-Aktor 1 wird vorzugsweise in einem Einspritzsystem eines Kraftfahrzeuges eingesetzt. Dabei wird der Piezo-Aktor 1 insbesondere im Hochdruckraum des Einspritzsystem angeordnet. Das Einspritzsystem ist vorzugsweise als ein Common-Rail-Einspritzsystem ausgebildet.

Obwohl die vorliegende Erfindung vorstehend anhand der bevorzugten Ausführungsbeispiele beschrieben wurde, ist sie darauf nicht beschränkt, sondern auf vielfältige Art und Weise modifizierbar, wie in den beigefügten Ansprüchen beansprucht. Beispielsweise kann eine Passivierungsschicht zwischen dem Übertragungsmittel und dem Piezo-Stapel immer dann vorgesehen werden, wenn eine, insbesondere eine zusätzliche Passivierungsschicht für den Piezo-Stapel vorteilhaft ist. Außerdem ist es für den Fachmann klar, dass in Abhängigkeit des für die Umhüllung verwendeten Materials auch sämtliche Zwischenbereiche der in Figur 5 dargestellten Bereiche der Mischungen von Silizium-Öl und Keramikkügelchen zur erfindungsgemäßen Minimierung der Beanspruchungen der Umhüllung möglich sind.

## Patentansprüche

1. Piezo-Aktor (1) zum Einspritzen von Kraftstoff mit einem vorbestimmten Kraftstoffdruck (P); mit:
a) einer einen Aktor-Innenraum (2) zumindest seitlich begrenzenden Umhüllung (3), welche eine temperatur- und/oder druckabhängige erste Volumenänderung (ΔV1) aufweist;
b) einem in dem Aktor-Innenraum (2) angeordneten Piezo-Stapel (4), welcher eine temperatur- und/oder druckabhängige zweite Volumenänderung (ΔV2) aufweist;
c) einem zwischen dem Piezo-Stapel (4) und der Umhüllung (3) angeordneten Übertragungsmittel (5; 6, 7-10) zum Übertragen des außen an der Umhüllung (3) anliegenden Kraftstoffdrucks (P) auf den Piezo-Stapel (4), wobei das Übertragungsmittel (5; 6, 7-10) eine passivierende Flüssigkeit (5) aufweist, welche eine temperatur- und/oder druckabhängige dritte Volumenänderung (ΔV3) aufweist,
**dadurch gekennzeichnet,**
**dass** das Übertragungsmittel (5; 6, 7-10) weiter mehrere vorgeformte Körper (6, 7-10) aufweist, welche eine temperatur- und/oder druckabhängige vierte Volumenänderung (ΔV4) aufweisen, wobei das Verhältnis zwischen der passivierenden Flüssigkeit (5) und den vorgeformten Körpern (6, 7-10) derart eingestellt ist, dass die erste Volumenänderung (ΔV1) der Umhüllung (3) einer Gesamtvolumenänderung (ΔVin) des Aktor-Innenraums (2), welche zumindest die zweite, dritte und vierte Volumenänderung (ΔV2 - ΔV4) umfasst, im Wesentlichen entspricht.

2. Piezo-Aktor nach Anspruch 1,
**dadurch gekennzeichnet,**
**dass** der Aktor-Innenraum (2) durch eine Kopfplatte (11), eine Bodenplatte (12), die Umhüllung (3) und durch den Piezo-Stapel (4) begrenzt ist.

3. Piezo-Aktor nach Anspruch 1 oder 2,
**dadurch gekennzeichnet,**
**dass** eine Differenz zwischen der Gesamtvolumenänderung (ΔVin) des Aktor-Innenraums (2) und der ersten Volumenänderung (ΔV1) der Umhüllung (3) in einem vorbestimmten Toleranzbereich liegt.

4. Piezo-Aktor nach einem der vorstehenden Ansprüche,
**dadurch gekennzeichnet,**
**dass** der Piezo-Stapel (4) quaderförmig, **vieleckig** oder kreiszylindrisch ausgebildet ist.

5. Piezo-Aktor nach einem der vorstehenden Ansprüche,
**dadurch gekennzeichnet,**
**dass** die Umhüllung (3) als ein Wellrohr ausgebildet ist, welches eine Vielzahl von N Wellen aufweist und insbesondere metallisch ist.

6. Piezo-Aktor nach einem der vorstehenden Ansprüche,
**dadurch gekennzeichnet,**
**dass** die passivierende Flüssigkeit (5) als ein Silikon-Öl ausgebildet ist.

7. Piezo-Aktor nach einem der vorstehenden Ansprüche,
**dadurch gekennzeichnet,**
**dass** die vorgeformten Körper (6, 7-10) als eine Vielzahl von Kügelchen (6) ausgebildet sind, welche insbesondere jeweils einen Durchmesser von höchstens 200 µm aufweisen und/oder aus einer Oxid-Keramik bestehen.

8. Piezo-Aktor nach Anspruch 7,
**dadurch gekennzeichnet,**
**dass** die Kügelchen (6) in der passivierenden Flüssigkeit (5) in der dichtesten Kugelpackung angeordnet sind.

9. Piezo-Aktor nach Anspruch 5,
**dadurch gekennzeichnet,**
**dass** die vorgeformten Körper (6, 7-10) als elastische Übertragungselemente (7-10) ausgebildet sind, wobei vorzugsweise in zumindest einer Welle des Wellrohrs zumindest zwei an die Wellenform angepasste elastische Übertragungselemente (7-10) angeordnet sind.

10. Piezo-Aktor nach Anspruch 9,
**dadurch gekennzeichnet,**
**dass** das elastische Übertragungselement (7-10) aus Stahl und/oder Keramik und/oder Invar und/oder Nylon (PA66) und/oder aus einem Elastomer, insbesondere Teflon, ausgebildet ist.

11. Piezo-Aktor nach einem der Ansprüche 5, 9, 10,
**dadurch gekennzeichnet,**
**dass** das Wellrohr als ein längs- und querdehnfähiges Wellrohr ausgebildet ist.

12. Piezo-Aktor nach einem der vorstehenden Ansprüche,
**dadurch gekennzeichnet,**
**dass** das Übertragungsmittel (5; 6, 7-10) zwischen der Umhüllung (3) und dem Piezo-Stapel (4) formschlüssig und/oder kraftschlüssig angeordnet ist.

13. Piezo-Aktor nach einem der vorstehenden Ansprüche,
**dadurch gekennzeichnet,**
**dass** der Wärmeausdehnungskoeffizient der vorgeformten Körper (6, 7-10) um das Zehnfache bis Fünfzigfache, bevorzugt um das Zwanzigfache bis Vierzigfache, besonders bevorzugt um das Fünfundzwanzigfache bis Fünfunddreißigfache, kleiner als der Wärmeausdehnungskoeffizient der passivierenden Flüssigkeit (5) ist.

14. Verfahren zum Herstellen eines Piezo-Aktors (1) nach einem der vorstehenden Ansprüche 1 bis 13 mit den Schritten:
a) Anordnen eines Piezo-Stapels (4) in einem Aktor-Innenraum (2), wobei der Piezo-Stapel (4) eine temperatur- und/oder druckabhängige zweite Volumenänderung (ΔV2) aufweist;
b) zumindest seitliches Begrenzen des Aktor-Innenraums (2) mittels einer Umhüllung (3), welche eine temperatur- und/oder druckabhängige erste Volumenänderung (ΔV1) aufweist;
c) Füllen des verbleibenden Aktor-Innenraums (2) zwischen dem Piezo-Stapel (4) und der Umhüllung (3) mit einer passivierenden Flüssigkeit (5) zum Übertragen des an der Umhüllung (3) anliegenden Kraftstoffdrucks (P) auf dem Piezo-Stapel (4),
wobei die Flüssigkeit (5) eine temperatur- und/oder druckabhängige dritte Volumenänderung (ΔV3) aufweist,
**gekennzeichnet durch**
d) Einstellen einer Gesamtvolumenänderung (ΔVin), welche zumindest die zweite, dritte und vierte Volumenänderung (ΔV2 - ΔV4) umfasst, mittels Packen von mehreren vorgeformten Körpern (6, 7-10), welche eine temperatur- und/oder druckabhängige vierte Volumenänderung (ΔV4) aufweisen, in die passivierende Flüssigkeit (5) derart, dass die Gesamtvolumenänderung (ΔVin) des Aktor-Innenraums (2) der ersten Volumenänderung (ΔV1) der Umhüllung (3) im Wesentlichen entspricht.

15. Einspritzsystem mit einem Piezo-Aktor (1) nach einem der Ansprüche 1 bis 13,
wobei der Piezo-Aktor (1) in einem Hochdruckraum des Einspritzsystems angeordnet ist.

16. Einspritzsystem nach Anspruch 15,
**dadurch gekennzeichnet,**
**dass** das Einspritzsystem als ein Common-Rail-Einspritzsystem ausgebildet ist.

## Claims

1. Piezo actuator (1) for injecting fuel with a predetermined fuel pressure (P); with
a) A jacket (3) at least laterally delimiting an actuator inner space (2) which exhibits a first change in volume (ΔV1) dependent on temperature and/or pressure;
b) A piezo stack (4) arranged in the actuator inner space (2) which exhibits a second change in volume (ΔV2) dependent on temperature and/or pressure;
c) A transmission means (5; 6, 7-10) arranged between the piezo stack (4) and the jacket (3) for transmitting to the piezo stack (4) the fuel pressure (P) obtaining outside at the jacket (3), with the transmission means (5; 6, 7-10) featuring a passivating liquid (5) which exhibits a third change in volume (ΔV3) dependent on temperature and/or pressure,
**characterized in that**,
the transmission means (5; 6, 7-10) has further preformed bodies (6, 7-10) which exhibit a fourth change in volume (ΔV4) dependent on temperature and/or pressure, with the ratio between the passivating liquid (5) and the preformed body (6, 7-10) being set such that the first change in volume (ΔV1) of the jacket (3) essentially corresponds to an overall change in volume (ΔVin) of the actuator inner space (2), which includes at least the second, third and fourth change in volume (ΔV2 - ΔV4).

2. Piezo actuator in accordance with claim 1,
**characterised in that**,
the actuator inner space (2) is delimited by a top plate (11), a bottom plate (12), the jacket (3) and by the piezo stack (4).

3. Piezo actuator in accordance with claim 1 or 2,
**characterised in that**,
a difference between the overall change of volume (ΔVin) of the actuator inner space (2) and the first change of volume (ΔV1) of the jacket (3) lies within a predetermined range of tolerances.

4. Piezo actuator in accordance with one of the previous claims,
**characterised in that**,
the piezo stack (4) is embodied as a cuboid, a polygon or a circular cylinder.

5. Piezo actuator in accordance with one of the previous claims,
**characterised in that**,
the jacket (3) is embodied as a corrugated tube which has a plurality of N corrugations and especially is metallic.

6. Piezo actuator in accordance with one of the previous claims,
**characterised in that**,
the passivating liquid (5) is embodied as a silicon oil.

7. Piezo actuator in accordance with one of the previous claims,
**characterised in that**,
the preformed bodies (6, 7-10) are embodied as a plurality of small spheres (6) which especially each have a diameter of at most 200 µm and/or consist of an oxide-ceramic.

8. Piezo actuator in accordance with claim 7,
**characterised in that**,
the small spheres (6) in the passivating liquid (5) are packed together in an arrangement for maximum density.

9. Piezo actuator in accordance with claim 5,
**characterised in that**,
the preformed bodies (6, 7-10) are embodied as elastic transmission elements (7-10), with preferably at least two elastic transmission elements (7-10) adapted to the shape of the corrugation being arranged in at least one corrugation of the corrugated tube.

10. Piezo actuator in accordance with claim 9,
**characterised in that**,
the elastic transmission element (7-10) is embodied from steel and/or ceramic and/or Invar and/or nylon (PA66) and/or from an elastomer, especially Teflon.

11. Piezo actuator in accordance with one of the claims 5, 9, 10,
**characterised in that**,
the corrugated tube is embodied as a corrugated tube able to be expanded lengthways and crossways.

12. Piezo actuator in accordance with one of the previous claims,
**characterised in that**,
the transmission means (5; 6, 7-10) is arranged between the jacket (3) and the piezo stack (4) to form a close fit or an interference fit.

13. Piezo actuator in accordance with one of the previous claims,
**characterised in that**,
the coefficient or thermal expansion of the preformed body (6, 7-10) is around a tenth to a fiftieth, preferably around a twentieth to a fortieth, preferably around a twenty-fifth to a thirty-fifth less than the coefficient of thermal expansion of the passivating liquid (5).

14. Method for manufacturing a piezo actuator (1) in accordance with one of the previous claims 1 to 13 with the following steps:
a) Arrangement of a piezo stack (4) in an actuator inner space (2), with the piezo stack (4) exhibiting a second change in volume (ΔV2) dependent on temperature and/or pressure;
b) At least lateral delimiting of the actuator inner space (2) by means of a jacket (3), which exhibits a first change in volume (ΔV1) dependent on temperature and/or pressure;
c) Filling of the remainder of the actuator inner space (2) between the piezo stack (4) and the jacket (3) with a passivating liquid (5) for transmitting to the piezo stack (4) the fuel pressure being exerted on the jacket (3), with the liquid (5) exhibiting a third change in volume (ΔV3) which changes with temperature and/or pressure,
**characterised by**
d) Setting of an overall change in volume (ΔVin), which includes at least the second, third and fourth change in volume (ΔV2, ΔV4), be means of packing a number of preformed bodies (6, 7-10), which exhibit a fourth change in volume (ΔV4) dependent on temperature and/or pressure into the passivating liquid (5) such that the overall change in volume (ΔVin) of the actuator inner space (2) essentially corresponds to the first change in volume (ΔV1) of the jacket (3).

15. Injection system with a piezo actuator (1) in accordance with one of claims 1 to 13,
with the piezo actuator (1) being arranged in a high-pressure space of the injection system.

16. Injection system in accordance with claim 15,
**characterised in that**
the injection system is embodied as a common rail injection system,

## Revendications

1. Actionneur piézo-électrique (1) destiné à injecter du carburant avec une pression de carburant (P) prédéterminée comprenant :
a) une enveloppe (3) délimitant au moins latéralement un espace intérieur (2) de l'actionneur, qui présente une première variation de volume (Δv1) en fonction de la température et/ou de la pression ;
b) un empilement piézo-électrique (4) disposé dans l'espace intérieur (2) de l'actionneur, qui présente une deuxième variation de volume (Δv2) en fonction de la température et/ou de la pression ;
c) un moyen de transmission (5 ; 6, 7-10) disposé entre l'empilement piézo-électrique (4) et l'enveloppe (3), destiné à transmettre à l'empilement piézo-électrique (4) la pression du carburant (P) appliquée extérieurement à l'enveloppe (3), le moyen de transmission (5 ; 6, 7-10) présentant un liquide passivant (5) qui présente une troisième variation de volume (Δv3) en fonction de la température et/ou de la pression,
**caractérisé**
**en ce que** le moyen de transmission (5 ; 6, 7-10) présente en outre plusieurs corps préformés (6, 7-10) qui présentent une quatrième variation de volume (Δv4) en fonction de la température et/ou de la pression, le rapport entre le liquide passivant (5) et les corps préformés (6, 7-10) étant réglé de telle manière que la première variation de volume (Δv1) de l'enveloppe (3) corresponde sensiblement à une variation de volume totale (Δvin) de l'espace intérieur (2) de l'actionneur qui comprend au moins les deuxième, troisième et quatrième variations de volume (Δv2 - Δv4).

2. Actionneur piézo-électrique selon la revendication 1,
**caractérisé**
**en ce que** l'espace intérieur (2) de l'actionneur est limité par une plaque de tête (11), une plaque de fond (12), l'enveloppe (3) et l'empilement piézo-électrique (4).

3. Actionneur piézo-électrique selon la revendication 1 ou 2,
**caractérisé**
**en ce qu'**une différence entre la variation de volume totale (Δvin) de l'espace intérieur (2) de l'actionneur et la première variation de volume (Δv1) de l'enveloppe (3) est comprise dans une plage de tolérance prédéterminée.

4. Actionneur piézo-électrique selon une des revendications précédentes,
**caractérisé**
**en ce que** l'empilement piézo-électrique (4) est de forme parallélépipédique rectangle, polygonale ou cylindrique à base circulaire.

5. Actionneur piézo-électrique selon l'une des revendications précédentes,
**caractérisé**
**en ce que** l'enveloppe (3) est en forme d'un tuyau annelé qui présente une pluralité de N anneaux et qui est en particulier métallique.

6. Actionneurs piézo-électrique selon une des revendications précédentes,
**caractérisé**
**en ce que** le liquide passivant (5) comporte une huile de silicone.

7. Actionneur piézo-électrique selon l'une des revendications précédentes,
**caractérisé**
**en ce que** les corps préformés (6, 7-10) comportent une pluralité de petites billes (6) qui présentent en particulier chacune un diamètre de 200 µm au maximum et/ou comportent une céramique oxydée.

8. Actionneur piézo-électrique selon la revendication 7,
**caractérisé**
**en ce que** les petites billes (6) sont disposées dans le liquide passivant (5) avec un tassement très dense.

9. Actionneur piézo-électrique selon la revendication 5,
**caractérisé**
**en ce que** les corps préformés (6, 7-10) comportent des éléments de transmission élastiques (7-10), auquel cas de préférence dans au moins un anneau du tuyau annelé, sont disposés au moins deux éléments de transmission élastiques (7-10) adaptés à la forme de l'anneau.

10. Actionneur piézo-électrique selon la revendication 9,
**caractérisé**
**en ce que** l'élément de transmission élastique (7-10) est fait d'acier et/ou de céramique et/ou d'Invar et/ou de nylon (PA66) et/ou d'un élastomère, en particulier de Téflon.

11. Actionneur piézo-électrique selon l'une des revendications 5, 9 ou 10 **caractérisé en ce que** le tuyau annelé est en forme d'un tuyau annelé extensible en longueur est transversalement.

12. Actionneur piézo-électrique selon l'une des revendications précédentes,
**caractérisé**
**en ce que** le moyen de transmission (5 ; 6, 7-10) est disposé entre l'enveloppe (3) et l'empilement piézo-électrique (4) avec assemblage par complémentarité de forme et/ou par action de force.

13. Actionneur piézo-électrique selon l'une des revendications précédentes,
**caractérisé**
**en ce que** le coefficient de dilatation thermique des corps préformés (6, 7-10) est 10 à 50 fois, de préférence 20 à 40 fois, dans un mode particulièrement préféré 25 à 35 fois, plus petit que le coefficient de dilatation thermique du liquide passivant (5).

14. Procédé de fabrication d'un actionneur piézo-électrique (1) selon l'une des revendications précédentes 1 à 13, comprenant les étapes suivantes :
a) disposer un empilement piézo-électrique (4) dans un espace intérieur d'actionneur (2), l'empilement piézo-électrique (4) présentant une deuxième variation de volume (ΔV2) en fonction de la température et/ou de la pression ;
b) limiter au moins latéralement l'espace intérieur d'actionneur (2) au moyen d'une enveloppe (3) qui présente une première variation de volume (Δv1) en fonction de la température et/ou de la pression ;
c) remplir le volume intérieur d'actionneur (2) restant entre l'empilement piézo-électrique (4) et l'enveloppe (3) avec un liquide passivant (5) destiné à transmettre la pression de carburant (P) appliquée à l'enveloppe (3) à l'empilement piézo-électrique (4), le liquide (5) présentant une troisième variation de volume (Δv3) en fonction de la température et/ou de la pression,
**caractérisé en ce qu'**il comprend l'étape :
d) régler une variation de volume totale (ΔVin), qui comprend au moins les deuxième, troisième et quatrième variations de volume (ΔV2 - ΔV4) en entassant plusieurs corps préformés (6, 7-10) qui présentent une quatrième variation de volume (ΔV4) en fonction de la température et/ou de la pression, dans le liquide passivant (5) de telle manière que la variation volumique totale (ΔVin) de l'espace intérieur (2) de l'actionneur corresponde sensiblement à la première variation de volume (ΔV1) de l'enveloppe (3).

15. Système d'injection comprenant un actionneur piézo-électrique (1) selon l'une des revendications 1 à 13,
dans lequel l'actionneur piézo-électrique (1) est disposé dans une chambre à haute pression du système d'injection.

16. Système d'injection selon la revendication 15,
**caractérisé**
**en ce que** le système d'injection est constitué par un système d'injection à rampe commune.
